# EUROPÄISCHE PATENTSCHRIFT

(11) **EP 2 786 475 B1**
(45) Veröffentlichungstag und Bekanntmachung des Hinweises auf die Patenterteilung: **03.06.2020**
(21) Anmeldenummer: 12805969.8
(22) Anmeldetag: 29.11.2012
(51) Int. Cl.: H02M 3/335, G01R 31/40

(54) **SCHALTUNGSANORDNUNG UND VERFAHREN ZUM ERMITTELN VON SCHALTZEITEN EINES GLEICHSPANNUNGSWANDLERS**
CIRCUIT ARRANGEMENT AND METHOD FOR ASCERTAINING SWITCHING TIMES FOR A DC-DC VOLTAGE CONVERTER
CIRCUITERIE ET PROCÉDÉ POUR DÉTERMINER DES TEMPS DE COMMUTATION D'UN CONVERTISSEUR DE TENSION CONTINUE

(30) Priorität: 02.12.2011 DE 102011087668
(43) Veröffentlichungstag der Anmeldung: 08.10.2014
(73) Patentinhaber: Conti Temic Microelectronic GmbH, 90411 Nürnberg (DE)
(72) Erfinder: MÜHLENBROCK, Peter, 90427 Nürnberg (DE)
(74) Vertreter: Bonn, Roman Klemens
(86) Internationale Anmeldenummer: PCT/EP2012/073967
(87) Internationale Veröffentlichungsnummer: WO 2013/079595

(56) Entgegenhaltungen:
- EP-A1- 1 722 466
- DE-A1-102009 001 531
- US-A1- 2009 016 083

## Beschreibung

Die Anmeldung betrifft Schaltungsanordnungen und Verfahren zum Ermitteln von Schaltzeiten eines Gleichspannungswandlers, Gleichspannungswandler und ein Fahrzeug-Bordnetz mit einem Gleichspannungswandler.

Aus der EP 1 722 466 A1 ist ein Verfahren und eine Steuerschaltung bekannt, das bzw. die in einer neuen und effektiven Weise eine Steuerspannung eines synchronen Gleichrichtertransistors mit einer gewünschten Vorlaufzeit erzeugt. Die Vorlaufzeit wird kontinuierlich mit einer "Closed-Loop"-Technik durch Vergleich mit der Dauer eines Referenzimpulses geregelt.

Aus der DE 10 2009 001531 A1 ist ein Verfahren zum Betreiben eines Transistors als Gleichrichtelement bekannt, wobei der Transistor einen Zustand mit einer Vorspannung in Rückwärtsrichtung oder einen Zustand mit einer Vorspannung in Vorwärtsrichtung annehmen kann und wobei der Transistor durch ein Steuersignal angesteuert wird, das einen Einschalt-Pegel und einen Ausschalt-Pegel annehmen kann.

Aus der US 2009/016083 A1 ist ein Resonanzwandler mit einer primärseitigen Schaltstufe mit hoch- und niedrigseitigen Schaltern bekannt, die an einem Schaltknoten angeschlossen sind und von einer primärseitigen Steuerung gesteuert werden.

Aus der US 7 889 524 B2 ist ein Leistungsmodul für ein Hybrid-Elektrofahrzeug mit einem integrierten Wandler bekannt, der einen Gleichrichter zum Wandeln von Wechselspannung in Gleichspannung, einen Gleichspannungswandler zum Wandeln einer ersten Spannung in eine zweite Spannung und eine Batterie zum Speichern elektrischer Energie beinhaltet. Der integrierte Wandler arbeitet in drei Modi: 1) AC-Lademodus, 2) Hochsetz-Modus zum Bereitstellen von Leistung von der Batterie an den elektrischen Bus und 3) Tiefsetz-Modus zum Bereitstellen von Leistung von dem elektrischen Bus an die Batterie.

Aufgabe der Anmeldung ist es, Schaltungsanordnungen und Verfahren zum Ermitteln von Schaltzeiten eines Gleichspannungswandlers anzugeben, welche einen verbesserten Betrieb eines Gleichspannungswandlers ermöglichen. Weiterhin ist es Aufgabe der Anmeldung, entsprechende Gleichspannungswandler anzugeben.

Diese Aufgabe wird mit dem Gegenstand der unabhängigen Ansprüche gelöst. Vorteilhafte Weiterbildungen ergeben sich aus den abhängigen Ansprüchen.

Eine Schaltungsanordnung zum Ermitteln von Schaltzeiten eines Gleichspannungswandlers weist gemäß einem ersten Aspekt der Anmeldung eine Ansteuereinheit auf, die zum Ansteuern von auf einer Hochvoltseite des Gleichspannungswandlers angeordneten Leistungsschaltern einer Vollbrücke ausgebildet ist. Zudem weist die Schaltungsanordnung zumindest eine erste Vergleichseinheit auf, die zum Vergleichen einer, über einen auf einer Niedervoltseite des Gleichspannungswandlers angeordneten Leistungsschalter abfallenden ersten Spannung U_{LV} mit einer ersten vorbestimmten Referenzspannung U_{ref} ausgebildet ist. Weiterhin weist die Schaltungsanordnung eine erste Messeinheit auf, ausgebildet zum Starten einer ersten Zeitmessung, falls bzw. sobald ein Paar der Leistungsschalter der Vollbrücke mittels der Ansteuereinheit eingeschaltet wird und zum Beenden der ersten Zeitmessung, falls bzw. sobald die erste Spannung U_{LV} die erste Referenzspannung U_{ref} überschreitet: U_{LV} > U_{ref}. Die erste Messeinheit ist zudem zum Ausgeben einer ermittelten ersten Messdauer der ersten Zeitmessung an die Ansteuereinheit ausgebildet und die Ansteuereinheit ist zum Ansteuern der Leistungsschalter in Abhängigkeit der ermittelten ersten Messdauer ausgebildet.

Die auf der Hochvoltseite des Gleichspannungswandlers angeordneten Leistungsschalter der Vollbrücke werden paarweise vorzugsweise von pulsweitenmodulierten Ansteuersignalen angesteuert geschaltet. Dabei dient die von der Messeinheit ermittelte Messdauer der Zeitmessung dazu, den Tastgrad also den Ansteuergrad der pulsweitenmodulierten Ansteuersignale und somit die Ein- und Ausschaltzeit der jeweiligen Leistungsschalter einzustellen. Dies gilt analog für die nachfolgend zu beschreibenden Aspekte der Erfindung.

Der Begriff Hochvoltseite wird hier und im Folgenden synonym zu dem Begriff Hochspannungsseite verwendet. Weiterhin wird der Begriff Niedervoltseite hier und im Folgenden synonym zu dem Begriff Niederspannungsseite verwendet.

Die Schaltungsanordnung gemäß der genannten Ausführungsform ermöglicht einen verbesserten Betrieb des Gleichspannungswandlers durch das Vorsehen der entsprechend ausgebildeten ersten Messeinheit sowie der Ansteuereinheit, die zum Ansteuern der Leistungsschalter in Abhängigkeit der ermittelten ersten Messdauer ausgebildet ist. Mittels der genannten Schaltungsanordnung kann die Verzögerungszeit zwischen dem Betätigen der Vollbrücke und dem Zeitpunkt, an dem die generierte Spannung auf der Niedervoltseite auftritt, gemessen werden. Damit können Toleranzen im Schaltverhalten der Bauteile, insbesondere der Leistungsschalter, beispielsweise aufgrund von Temperaturschwankungen, Alterung und Fertigungstoleranzen, automatisch ermittelt und daraus abgeleitete, verbesserte bzw. optimierte Timing-Einstellungen zum Ansteuern der Leistungsschalter verwendet werden. Dies ermöglicht in vorteilhafter Weise eine Steigerung des Wirkungsgrads und einen stabileren Betrieb des Gleichspannungswandlers. Das Schaltverhalten wird dabei im laufenden Betrieb des Gleichspannungswandlers ermittelt, wobei lediglich eine Spannungsmessung, jedoch keine Strommessung erforderlich ist.

In einer Ausführungsform der Schaltungsanordnung ist die Ansteuereinheit außerdem ausgebildet zum Ansteuern von auf einer Niedervoltseite des Gleichspannungswandlers angeordneten Leistungsschaltern. Ferner weist die Schaltungsanordnung eine Ermittlungseinheit auf, die zum Ermitteln einer zweiten Referenzspannung U'_{ref} ausgebildet ist. Darüber hinaus weist die Schaltungsanordnung zumindest eine zweite Vergleichseinheit auf, die zum Vergleichen einer über einen der auf der Niedervoltseite des Gleichspannungswandlers angeordneten Leistungsschalter abfallenden zweiten Spannung U'_{LV} mit der zweiten Referenzspannung U'_{ref} ausgebildet ist. Weiterhin weist die Schaltungsanordnung eine zweite Messeinheit auf, ausgebildet zum Starten einer zweiten Zeitmessung, falls bzw. sobald der Leistungsschalter mittels der Ansteuereinheit ausgeschaltet wird und zum Beenden der zweiten Zeitmessung, falls bzw. sobald der Betrag |U'_{LV}| der zweiten Spannung U'_{LV} den Betrag |U'_{ref}| der zweiten Referenzspannung U'_{ref} überschreitet: |U'_{LV}| > |U'_{ref}|. Zudem ist die zweite Messeinheit ausgebildet zum Starten einer dritten Zeitmessung, falls bzw. sobald der Leistungsschalter mittels der Ansteuereinheit eingeschaltet wird und zum Beenden der dritten Zeitmessung, falls bzw. sobald der Betrag |U'_{LV}| der zweiten Spannung U'_{LV} den Betrag |U'_{ref}| der zweiten Referenzspannung U'_{ref} unterschreitet: |U'_{LV}| < |U'_{ref}|. Die zweite Messeinheit ist zudem zum Ausgeben einer ermittelten zweiten Messdauer der zweiten Zeitmessung und einer ermittelten dritten Messdauer der dritten Zeitmessung an die Ansteuereinheit ausgebildet und die Ansteuereinheit ist zum Ansteuern des Leistungsschalters in Abhängigkeit der ermittelten zweiten und dritten Messdauer ausgebildet.

In einer Ausführungsform der Schaltungsanordnung ist die zumindest eine erste Vergleichseinheit als Komparator ausgebildet. In einer weiteren Ausgestaltung kann die zumindest eine erste Vergleichseinheit ein Potentiometer aufweisen. Beide Ausgestaltungen ermöglichen, die abfallende erste Spannung U_{LV} in einfacher Weise mit der ersten Referenzspannung U_{ref} zu vergleichen.

Weiterhin kann die Schaltungsanordnung in einer weiteren Ausführungsform einen Pulsweitenmodulator zum Erzeugen der ersten Referenzspannung U_{ref} aufweisen. Die erste Referenzspannung U_{ref} wird dabei vorzugsweise aus einem von dem Pulsweitenmodulator erzeugten pulsweitenmodulierten Spannungssignal durch anschließende Tiefpassfilterung erzeugt, wobei die Höhe der ersten Referenzspannung U_{ref} von dem Tastgrad des pulsweitenmodulierten Spannungssignals abhängig eingestellt werden kann. Der Tastgrad bzw. die Höhe der Referenzspannung wird beispielsweise abhängig von dem gewünschten Spannungswert auf der Niedervoltseite des Gleichspannungswandlers eingestellt bzw. vorgegeben. Findet eine Spannungswandlung von der Niedervoltseite des Gleichspannungswandlers in die Hochvoltseite des Gleichspannungswandlers statt, so wird der Tastgrad bzw. die Referenzspannung beispielsweise abhängig von dem gewünschten Spannungswert auf der Hochvoltseite des Gleichspannungswandlers eingestellt bzw. vorgegeben. Dies gilt analog für die nachfolgend zu beschreibenden Aspekte der Erfindung.

Gemäß einem zweiten Aspekt der Anmeldung wird eine Schaltungsanordnung zum Ermitteln von Schaltzeiten eines Gleichspannungswandlers bereitgestellt, die eine Ansteuereinheit aufweist, welche zum Ansteuern von auf einer Niedervoltseite des Gleichspannungswandlers angeordneten Leistungsschaltern ausgebildet ist. Ferner weist die Schaltungsanordnung eine Ermittlungseinheit auf, die zum Ermitteln einer ersten Referenzspannung U'_{ref,1} und einer zweiten Referenzspannung U'_{ref,2} ausgebildet ist. Dabei gilt |U'_{ref,1}| < |U'_{ref,2}|. Darüber hinaus weist die Schaltungsanordnung zwei Vergleichseinheiten auf, die zum Vergleichen einer über einen der auf der Niedervoltseite des Gleichspannungswandlers angeordneten Leistungsschalter abfallenden Spannung U'_{LV} mit jeweils einer der beiden Referenzspannungen U'_{ref,1}, U'_{ref,2} ausgebildet sind. Weiterhin weist die Schaltungsanordnung eine Messeinheit auf, ausgebildet zum Starten einer ersten Zeitmessung, falls bzw. sobald der Leistungsschalter mittels der Ansteuereinheit ausgeschaltet wird und zum Beenden der ersten Zeitmessung, falls bzw. sobald der Betrag |U'_{LV}| der Spannung U'_{LV} den Betrag |U'_{ref,1}| der ersten Referenzspannung U'_{ref,1} überschreitet: |U'_{LV}| > |U'_{ref,1}|. Zudem ist die Messeinheit ausgebildet zum Starten einer zweiten Zeitmessung, falls bzw. sobald der Leistungsschalter mittels der Ansteuereinheit eingeschaltet wird und zum Beenden der zweiten Zeitmessung, falls bzw. sobald der Betrag |U'_{LV}| der Spannung U'_{LV} den Betrag |U'_{ref,2}| der zweiten Referenzspannung U'_{ref,2} unterschreitet: |U'_{LV}| < |U'_{ref,2}|. Die Messeinheit ist zudem zum Ausgeben einer ermittelten ersten Messdauer der ersten Zeitmessung und einer ermittelten zweiten Messdauer der zweiten Zeitmessung an die Ansteuereinheit ausgebildet und die Ansteuereinheit ist zum Ansteuern des Leistungsschalters in Abhängigkeit der ermittelten ersten und zweiten Messdauer ausgebildet.

Die Schaltungsanordnung gemäß der genannten Ausführungsform ermöglicht wiederum einen verbesserten Betrieb des Gleichspannungswandlers, indem Toleranzen im Schaltverhalten der auf der Niedervoltseite angeordneten Leistungsschalters ermittelt und optimierte Timing-Einstellungen, also Zeitablaufeinstellung für die Ansteuereinheit bestimmt werden. Dazu werden die Ein- und Ausschalt-Zeiten der Leistungsschalter bestimmt und an die Ansteuereinheit ausgegeben.

Die Vergleichseinheiten sind in einer Ausführungsform der Schaltungsanordnung als Komparatoren ausgebildet. In einer weiteren Ausführungsform weist die Ermittlungseinheit einen Dreizustandspuffer (auf Englisch "Tri-State Buffer") und ein D-Flipflop auf. Dies ermöglicht eine Ermittlung der Referenzspannung U'_{ref} in einfacher Weise.

Gemäß einem dritten Aspekt der Erfindung wird ein Gleichspannungswandler zur Umwandlung einer Spannung einer Hochvoltseite des Gleichspannungswandlers in eine Spannung einer Niedervoltseite des Gleichspannungswandlers und/oder umgekehrt bereitgestellt. Dabei umfasst der Gleichspannungswandler eine Vollbrücke mit Leistungsschaltern auf der Niedervoltseite und/oder Leistungsschalter auf der Niedervoltseite des Gleichspannungswandlers. Ferner weist der Gleichspannungswandler eine der oben beschriebenen Schaltungsanordnungen zur Steuerung der Leistungsschalter der Vollbrücke auf der Hochvoltseite des Gleichspannungswandlers und/oder der Leistungsschalter auf der Niedervoltseite des Gleichspannungswandlers auf.

Der Gleichspannungswandler weist dabei die im Zusammenhang mit der entsprechenden Schaltungsanordnung genannten Vorteile auf, welche an dieser Stelle zur Vermeidung von Wiederholungen nicht nochmals aufgeführt werden.

Die Leistungsschalter sind bevorzugt als Metall-Oxid- Halbleiter-Feldeffekttransistoren also MOSFETs ausgebildet, insbesondere als n-Kanal MOSFETs.

Gemäß einem vierten Aspekt der Anmeldung wird ein Fahrzeug-Bordnetz bereitgestellt, das einen oben beschriebenen Gleichspannungswandler aufweist. Das Fahrzeug-Bordnetz ist beispielsweise Bestandteil eines Elektrofahrzeugs oder eines Hybridfahrzeugs. Weiterhin kann ein Gleichspannungswandler gemäß einer der oben genannten Ausführungsformen Bestandteil eines Schaltnetzteiles sein.

Gemäß einem fünften Aspekt der Anmeldung wird ein Verfahren zum Ermitteln von Schaltzeiten eines Gleichspannungswandlers bereitgestellt, wobei das Verfahren folgende Schritte aufweist. Es erfolgt ein Starten einer Zeitmessung, falls bzw. sobald ein Paar von auf einer Hochvoltseite des Gleichspannungswandlers angeordneten Leistungsschaltern einer Vollbrücke mittels einer Ansteuereinheit eingeschaltet wird. Zudem erfolgt ein Vergleichen einer, über einen auf einer Niedervoltseite des Gleichspannungswandlers angeordneten Leistungsschalter abfallenden Spannung U_{LV} mit einer vorbestimmten Referenzspannung U_{ref}. Weiterhin erfolgt ein Beenden der Zeitmessung, falls bzw. sobald die erste Spannung U_{LV} die erste Referenzspannung U_{ref} überschreitet: U_{LV} > U_{ref}, und ein Ausgeben einer ermittelten Messdauer der Zeitmessung an die Ansteuereinheit. Des Weiteren erfolgt ein Ansteuern der Leistungsschalter in Abhängigkeit der ermittelten Messdauer.

In einer Ausführungsform umfasst das Verfahren vorzugsweise ferner folgende Verfahrensschritte. Es erfolgt ein Ermitteln einer weiteren Referenzspannung U'_{ref} und ein Starten einer weiteren Zeitmessung, falls bzw. sobald ein auf einer Niedervoltseite des Gleichspannungswandlers angeordneter Leistungsschalter mittels der Ansteuereinheit ausgeschaltet wird. Zudem erfolgt ein Vergleichen einer über den Leistungsschalter abfallenden weiteren Spannung U'_{LV} mit der weiteren Referenzspannung U'_{ref} sowie ein Beenden der weiteren Zeitmessung, falls bzw. sobald der Betrag |U'_{LV}| der weiteren Spannung U'_{LV} den Betrag |U'_{ref}| der weiteren Referenzspannung U'_{ref} überschreitet: |U'_{LV}| > |U'_{ref}|. Ferner erfolgt ein Ausgeben einer ermittelten weiteren Messdauer der weiteren Zeitmessung an die Ansteuereinheit und ein Ansteuern des Leistungsschalters in Abhängigkeit der ermittelten weiteren Messdauer.

In einer weiteren Ausführungsform umfasst das Verfahren vorzugsweise noch folgende Verfahrensschritte. Es erfolgt ein Starten einer noch weiteren Zeitmessung, falls bzw. sobald der Leistungsschalter mittels der Ansteuereinheit eingeschaltet wird. Zudem erfolgt ein Vergleichen der über den Leistungsschalter abfallenden weiteren Spannung U'_{LV} mit der weiteren Referenzspannung U'_{ref} sowie ein Beenden der noch weiteren Zeitmessung, falls bzw. sobald der Betrag |U'_{LV}| der weiteren Spannung U'_{LV} den Betrag |U'_{ref}| der weiteren Referenzspannung U'_{ref} unterschreitet: |U'_{LV}| < |U'_{ref}|. Des Weiteren erfolgt ein Ausgeben einer ermittelten noch weiteren Messdauer der noch weiteren Zeitmessung an die Ansteuereinheit und ein Ansteuern des Leistungsschalters in Abhängigkeit der ermittelten noch weiteren Messdauer.

Das Verfahren kann dabei insbesondere mittels einer Schaltungsanordnung gemäß einer der erstgenannten Ausführungsformen ausgeführt werden.

Gemäß einem sechsten Aspekt der Anmeldung wird ein weiteres Verfahren zum Ermitteln von Schaltzeiten eines Gleichspannungswandlers bereitgestellt, wobei das Verfahren folgende Schritte aufweist. Es erfolgt ein Ermitteln einer ersten Referenzspannung U'_{ref,1} und einer zweiten Referenzspannung U'_{ref,2} und ein Starten einer ersten Zeitmessung, falls bzw. sobald ein auf einer Niedervoltseite des Gleichspannungswandlers angeordneter Leistungsschalter mittels einer Ansteuereinheit ausgeschaltet wird. Zudem erfolgt ein Vergleichen einer über den Leistungsschalter abfallenden Spannung U'_{LV} mit der ersten Referenzspannung U'_{ref,1} sowie ein Beenden der ersten Zeitmessung, falls bzw. sobald der Betrag |U'_{LV}| der Spannung U'_{LV} den Betrag |U'_{ref,1}| der ersten Referenzspannung U'_{ref,1} überschreitet: |U'_{LV}| > |U'_{ref,1}|. Ferner erfolgt ein Ausgeben einer ermittelten ersten Messdauer der ersten Zeitmessung an die Ansteuereinheit und ein Ansteuern des Leistungsschalters in Abhängigkeit der ermittelten ersten Messdauer.

Das Verfahren kann dabei insbesondere mittels einer Schaltungsanordnung gemäß einer der zweitgenannten Ausführungsformen ausgeführt werden.

Die genannten Verfahren weisen die bereits im Zusammenhang mit den entsprechenden Schaltungsanordnungen genannten Vorteile auf, welche an dieser Stelle zur Vermeidung von Wiederholungen nicht nochmals aufgeführt werden.

Weiterhin kann das letztgenannte Verfahren zudem folgende Schritte aufweisen. Es erfolgt ein Starten einer zweiten Zeitmessung, falls bzw. sobald der Leistungsschalter mittels der Ansteuereinheit eingeschaltet wird. Zudem erfolgt ein Vergleichen der über den Leistungsschalter abfallenden Spannung U'_{LV} mit der zweiten Referenzspannung U'_{ref,2} sowie ein Beenden der zweiten Zeitmessung, falls bzw. sobald der Betrag |U'_{LV}| der Spannung U'_{LV} den Betrag |U'_{ref,2}| der zweiten Referenzspannung U'ref,2 unterschreitet: |U'_{LV}| < |U'_{ref,2}|. Des Weiteren erfolgt ein Ausgeben einer ermittelten zweiten Messdauer der zweiten Zeitmessung an die Ansteuereinheit und ein Ansteuern des Leistungsschalters in Abhängigkeit der ermittelten zweiten Messdauer.

Ausführungsformen der Anmeldung werden nun anhand der beigefügten Figuren näher erläutert.
- Figur 1: zeigt ein Prinzipschaltbild eines Gleichspannungswandlers;
- Figur 2: zeigt ein Blockschaltbild einer Schaltungsanordnung gemäß einer ersten Ausführungsform der Anmeldung;
- Figur 3: zeigt ein Blockschaltbild einer Schaltungsanordnung gemäß einer zweiten Ausführungsform der Anmeldung;
- Figur 4: zeigt ein Spannungs-Zeit-Diagramm eines Leistungsschalters;
- Figur 5: zeigt ein Flussdiagramm eines Verfahrens zum Ermitteln von Schaltzeiten eines Gleichspannungswandlers gemäß einer Ausführungsform der Anmeldung.

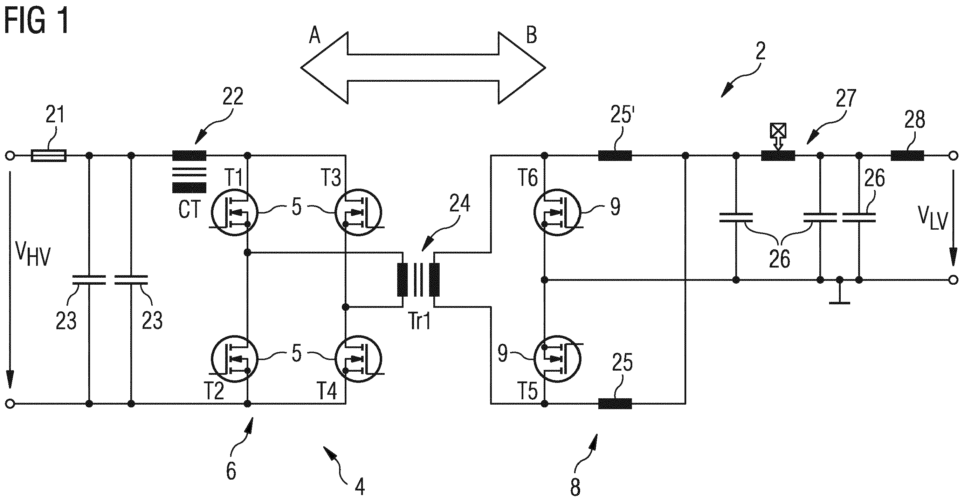

Figur 1 zeigt ein Prinzipschaltbild eines Gleichspannungswandlers 2.

Der Gleichspannungswandler 2 ist als bidirektionaler Wandler ausgebildet, der eine erste Gleichspannung V_{HV} bzw. U_{HV} in eine zweite, niedrigere Gleichspannung V_{LV} bzw. U_{LV} und umgekehrt umwandeln kann. Dies ist in Figur 1 schematisch mittels eines Pfeils A für die Umwandlung der zweiten Gleichspannung in die erste, höhere Gleichspannung gezeigt, wobei der Gleichspannungswandler 2 dabei als Aufwärtswandler, der auch als Hochsetzsteller oder Boost Converter bezeichnet wird, fungiert. Mittels eines Pfeils B ist die Umwandlung der ersten Gleichspannung in die zweite, niedrigere Gleichspannung gezeigt, wobei der Gleichspannungswandler 2 dabei als Abwärtswandler, der auch als Tiefsetzsteller bzw. Buck Converter bezeichnet wird, fungiert.

Der Gleichspannungswandler 2 weist dazu auf einer Hochvoltseite 4 eines Transformators 24 eine Vollbrücke 6 mit vier Leistungsschaltern 5 auf, wobei die Leistungsschalter 5 in der gezeigten Ausführungsform als n-Kanal MOSFETs T1, T2, T3 bzw. T4 ausgebildet sind. Der Transformator 24 besitzt beispielsweise einen Übertragungsfaktor zwischen 2 und 5.

Zudem ist auf der Hochvoltseite 4 des Gleichspannungswandlers 2 ein Sicherungselement 21 als Kurzschluss-Sicherung angeordnet. Weiterhin befinden sich auf der Hochvoltseite 4 zwei Kapazitäten bzw. Kondensatoren 23, die als Filter für hochfrequente Spannungsanteile fungieren, sowie ein Strommesselement 22, das auch als Stromtransformator (auf Englisch "Current Transformer") bezeichnet wird.

Auf einer Niedervoltseite 8 des Transformators 24 sind zwei Leistungsschalter 9 angeordnet, die ebenfalls als n-Kanal MOSFETs T5 bzw. T6 ausgebildet sind. Der drainseitige Anschluss des MOSFETs T5 ist dabei mit einer Induktivität 25 und der drainseitige Anschluss des MOSFETs T6 mit einer weiteren Induktivität 25' verbunden. Die Niedervoltseite 8 des Gleichspannungswandlers 2 bildet damit einen so genannten aktiven Stromverdoppler (auf Englisch "Active Current Doubler Rectifier").

Zudem sind auf der Niedervoltseite 8 des Gleichspannungswandlers 2 drei Kondensatoren 26 als Filterelemente sowie ein Strommesselement 27 angeordnet. Ferner ist ein Filterelement 28 in Form einer weiteren Induktivität auf der Niedervoltseite 8 angeordnet.

Der Gleichspannungswandler 2 ist beispielsweise Bestandteil eines nicht näher dargestellten Fahrzeug-Bordnetzes, beispielsweise eines Elektrofahrzeugs oder eines Hybridfahrzeugs, wobei das Fahrzeug insbesondere ein Personenkraftwagen sein kann.

Auf der Hochvoltseite 4 kann der Gleichspannungswandler 2 beispielsweise mit einem fahrzeugeigenen Generator, der durch Umschalten auch als Elektromotorantrieb eingesetzt werden kann, oder mit einem ersten Akkumulator, beispielsweise in Form eines Lithiumionenakkumulators, verbunden sein. Auf der Niedervoltseite 8 kann der Gleichspannungswandler 2 beispielsweise mit einem Bleiakkumulator des Fahrzeugs verbunden sein. Die Spannung V_{HV} beträgt beispielsweise zwischen 100 V und 800 V und die Spannung V_{LV} beispielsweise zwischen 6 V und 14 V.

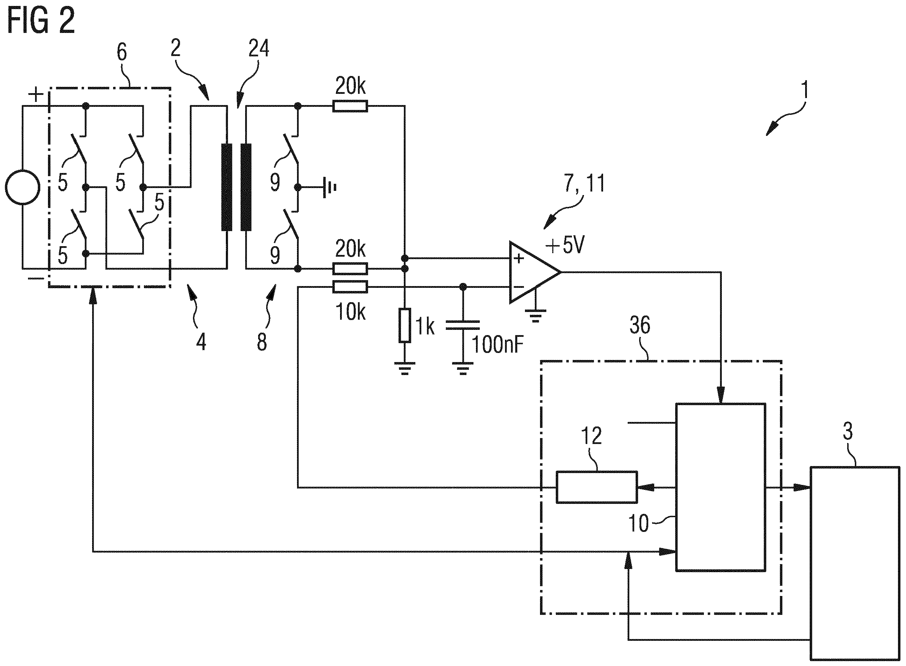

Figur 2 zeigt ein Blockschaltbild einer Schaltungsanordnung 1 zum Ermitteln von Schaltzeiten eines Gleichspannungswandlers 2 gemäß einer ersten Ausführungsform der Anmeldung. Aus Gründen der Übersichtlichkeit sind in Figur 2 nicht sämtliche der in Figur 1 dargestellten Komponenten des Gleichspannungswandlers 2 gezeigt. Komponenten mit den gleichen Funktionen wie in Figur 1 werden mit den gleichen Bezugszeichen gekennzeichnet und im Folgenden nicht nochmals erläutert.

Die Schaltungsanordnung 1 weist eine Ansteuereinheit 3 auf, die zum Ansteuern der auf der Hochvoltseite 4 des Gleichspannungswandlers 2 angeordneten Leistungsschalter 5 der Vollbrücke 6 ausgebildet ist. Die Leistungsschalter 5 sind dabei in Figur 2 lediglich schematisch dargestellt und als MOSFETs ausgebildet.

Zudem weist die Schaltungsanordnung 1 eine Vergleichseinheit 7 auf, die zum Vergleichen einer, über jeweils einen der auf der Niedervoltseite 8 des Gleichspannungswandlers 2 angeordneten Leistungsschalter 9 abfallenden Spannung U_{LV} mit einer Referenzspannung U_{ref} ausgebildet ist. Die Leistungsschalter 9 sind in Figur 2 ebenfalls lediglich schematisch dargestellt und als MOSFETs ausgebildet. Die Vergleichseinheit 7 ist in der gezeigten Ausführungsform als Komparator 11 ausgebildet, wobei die drainseitigen Anschlüsse der Leistungsschalter 9 jeweils über einen Widerstand mit dem positiven Eingang des Komparators 11 verbunden sind. Der negative Eingang des Komparators 11 ist in der gezeigten Ausführungsform über einen weiteren Widerstand mit einem Pulsweitenmodulator 12 verbunden, der zum Erzeugen der Referenzspannung U_{ref} dient.

Darüber hinaus weist die Schaltungsanordnung 1 eine Messeinheit 10 auf, ausgebildet zum Starten einer Zeitmessung, falls ein Paar der Leistungsschalter 5 der Vollbrücke 6, das heißt in der gezeigten Ausführungsform T1/T4 bzw. T2/T3, mittels der Ansteuereinheit 3 eingeschaltet wird. Dazu wird ein von der Ansteuereinheit 3 an die Leistungsschalter 5 ausgegebenes Ansteuersignal zudem an die Messeinheit 10 übermittelt. Dabei ist in Figur 2 aus Gründen der Übersichtlichkeit lediglich eine von vier Signalleitungen zwischen der Ansteuereinheit 3 und der Vollbrücke 6 schematisch dargestellt, die für die Ansteuerung der vier Leistungsschalter 5 vorgesehen sind. Ferner ist die Messeinheit 10 zum Beenden der Zeitmessung ausgebildet, falls U_{LV} > U_{ref}. Dazu ist die Messeinheit 10 mit dem Ausgang des Komparators 11 gekoppelt. Falls U_{LV} > U_{ref}, hat das Ausgangssignal des Komparators 11 einen hohen Pegel, wodurch die Zeitmessung beendet wird, wohingegen das Ausgangssignal des Komparators 11 einen niedrigen Pegel aufweist, falls U_{LV} ≤ U_{ref}.

Die Messeinheit 10 ist zudem zum Ausgeben einer ermittelten Messdauer der Zeitmessung an die Ansteuereinheit 3 ausgebildet und die Ansteuereinheit 3 ist zum Ansteuern der Leistungsschalter 5 in Abhängigkeit der ermittelten Messdauer ausgebildet.

In der gezeigten Ausführungsform sind die Messeinheit 10 sowie der Pulsweitenmodulator 12 als gemeinsamer Schaltungsblock 36 zum Ermitteln der Schaltzeiten des Gleichspannungswandlers 2 dargestellt. Mittels der gezeigten Schaltungsanordnung 1 wird die Verzögerungszeit zwischen dem Betätigen der H-Brücke bzw. Vollbrücke 6 und dem Zeitpunkt, an dem die generierte Spannung auf der Niedervoltseite 8 auftritt, gemessen. Entsprechend kann auch die Verzögerungszeit zwischen dem Abschalten der Vollbrücke 6 bis zu dem Zeitpunkt, an dem keine Spannung mehr auf der Niedervoltseite 8 vorhanden ist, bestimmt werden.

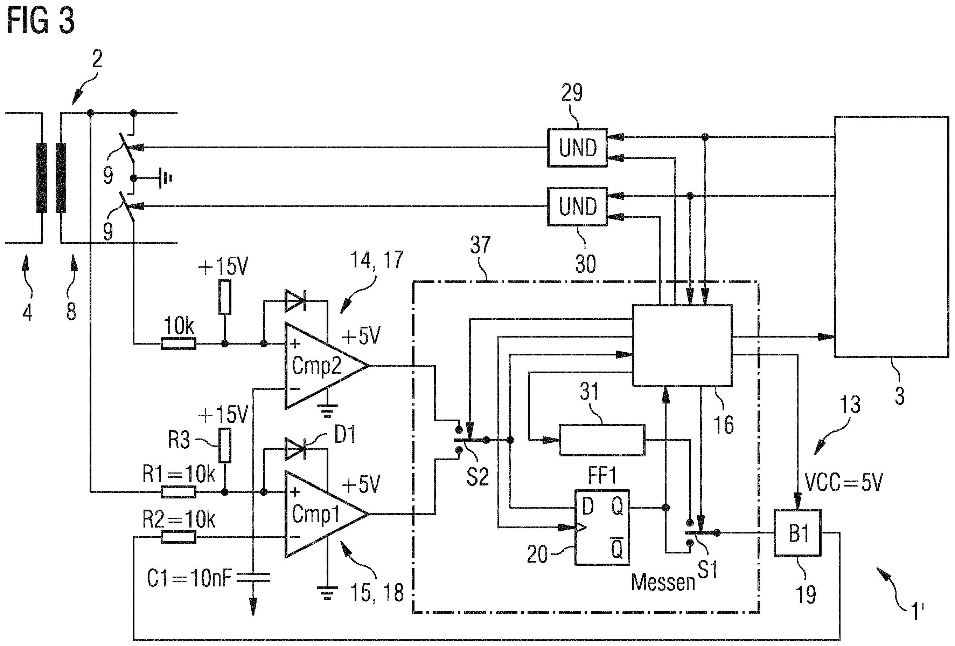

Figur 3 zeigt ein Blockschaltbild einer Schaltungsanordnung 1' zum Ermitteln von Schaltzeiten eines Gleichspannungswandlers 2 gemäß einer zweiten Ausführungsform der Anmeldung. Aus Gründen der Übersichtlichkeit sind wiederum nicht sämtliche der in Figur 1 gezeigten Komponenten des Gleichspannungswandlers 2 dargestellt. Komponenten mit den gleichen Funktionen wie in den vorhergehenden Figuren werden mit den gleichen Bezugszeichen gekennzeichnet und im Folgenden nicht nochmals erläutert.

Die Schaltungsanordnung 1' weist in der gezeigten Ausführungsform eine Ansteuereinheit 3 auf, die zum Ansteuern der auf der Niedervoltseite 8 des Gleichspannungswandlers 2 angeordneten Leistungsschalter 9 in Form von MOSFETs ausgebildet ist. Dazu ist die Ansteuereinheit 3 mit den Gate-Anschlüssen der Leistungsschalter 9 über jeweils ein Und-Gatter 29 bzw. 30 verbunden, wobei ein erster Eingang des Und-Gatters 29 bzw. ein erster Eingang des Und-Gatters 30 mit der Ansteuereinheit 3 gekoppelt ist.

Ferner weist die Schaltungsanordnung 1' eine Ermittlungseinheit 13 auf, die zum Ermitteln einer Referenzspannung U'_{ref} ausgebildet ist. Die Ermittlungseinheit 13 weist dazu einen Tri-State Buffer 19, der auch als B1 bezeichnet wird, und ein D-Flipflop 20, das auch als FF1 bezeichnet wird, auf. Weitere Einzelheiten zur Ermittlung der Referenzspannung U'_{ref} werden im Folgenden näher erläutert.

Der Tri-State Buffer 19 ist eingangsseitig mit einem Schalter S1 verbunden. Der Schalter S1 kann dabei zwischen einer ersten Position, die auch als "Messen" bezeichnet wird, und einer zweiten Position, die auch als "Festlegen Referenzspannung U'_{ref}" bezeichnet wird, geschaltet werden. Weiterhin ist der Schalteingang des Tri-State Buffer 19 mit einem Logikelement bzw. einer Messeinheit 16 der Schaltungsanordnung 1' verbunden. Der Daten-Eingang des D-Flipflop 20 ist ebenfalls mit der Messeinheit 16 verbunden. Weiterhin ist der Clock-Eingang des D-Flipflop 20 mit der Messeinheit 16 verbunden. Der Q-Ausgang des D-Flipflop 20 ist mit dem Schalter S1 sowie der Messeinheit 16 verbunden.

Das D-Flipflop 20, der Schalter S1 sowie die Messeinheit 16 bilden in der gezeigten Ausführungsform einen Schaltungsblock 37, der zudem einen Pulsweitenmodulator 31 zum Erzeugen der Referenzspannung U'_{ref} sowie einen zweiten Schalter S2 beinhaltet. Der Pulsweitenmodulator 31 ist eingangsseitig mit der Messeinheit 16 und ausgangsseitig mit der zweiten Position des Schalters S1 verbunden. Der zweite Schalter S2 kann zwischen einer ersten Position, die mit dem Ausgang eines ersten Komparators 18, der auch als Cmp1 bezeichnet wird, verbunden ist, und einer zweiten Position, die mit dem Ausgang eines zweiten Komparators 17, der auch als Cmp2 bezeichnet wird, verbunden ist, geschaltet werden und ist mit dem Daten-Eingang des D-Flipflop 20 verbunden. Zum Betätigen des ersten Schalters S1 und des zweiten Schalters S2 sind diese jeweils mit der Messeinheit 16 verbunden.

Weiterhin ist die Messeinheit 16 mit einem zweiten Eingang des ersten Und-Gatters 29 und einem zweiten Eingang des zweiten Und-Gatters 30 verbunden.

Die Komparatoren 17 bzw. 18 bilden in der gezeigten Ausführungsform zwei Vergleichseinheiten 14 und 15 der Schaltungsanordnung 1', die zum Vergleichen einer, über jeweils einen der auf der Niedervoltseite 8 des Gleichspannungswandlers 2 angeordneten Leistungsschalter 9 abfallenden Spannung U'_{LV} mit der Referenzspannung U'_{ref} ausgebildet sind. Der positive Eingang des ersten Komparators 18 ist über einen ersten Widerstand R1 mit dem drainseitigen Anschluss des ersten Leistungsschalters 9 verbunden. Der positive Eingang des zweiten Komparators 17 ist über einen weiteren Widerstand mit dem drainseitigen Anschluss des zweiten Leistungsschalters 9 verbunden. Die negativen Eingänge der beiden Komparatoren 17 und 18 sind jeweils über einen weiteren Widerstand R2 mit dem Ausgang des Tri-State Buffer 19 verbunden.

Die Messeinheit 16 ist zum Starten einer ersten Zeitmessung ausgebildet, falls einer der Leistungsschalter 9 mittels der Ansteuereinheit 3 ausgeschaltet wird, und zum Beenden der ersten Zeitmessung, falls |U'_{LV}| > |U'_{ref}|. Weiterhin ist die Messeinheit 16 ausgebildet zum Starten einer zweiten Zeitmessung, falls der Leistungsschalter 9 mittels der Ansteuereinheit 3 eingeschaltet wird, und zum Beenden der zweiten Zeitmessung, falls |U'_{LV}| < |U'_{ref}|.

Die Messeinheit 16 ist zudem zum Ausgeben einer ermittelten ersten Messdauer der ersten Zeitmessung und einer ermittelten zweiten Messdauer der zweiten Zeitmessung an die Ansteuereinheit 3 ausgebildet. Dazu ist die Messeinheit 16 mit der Ansteuereinheit 3 verbunden, wobei die Ansteuereinheit 3 zum Ansteuern der Leistungsschalter 9 in Abhängigkeit der ermittelten ersten und zweiten Messdauer ausgebildet ist.

Die Funktionsweise der Schaltungsanordnung 1' ist dabei derart, dass, falls der Schalter S1 in die Position "Messen" geschaltet und der Tri-State Buffer 19 aktiviert ist, der jeweilige Komparator 17 bzw. 18, das D-Flipflop 20 und die daran anhängenden Teile als Regelkreis fungieren. Der Ausgang des D-Flipflop 20 stellt die Spannung an dem Drain-Anschluss des jeweiligen Leistungsschalters 9 dar. Dazu wird das Tastverhältnis bestimmt, wie im Zusammenhang mit den folgenden Figuren näher erläutert wird. Falls der Regelkreis und der Tri-State Buffer 19 deaktiviert sind, bleibt die Spannung nahezu konstant bis der nächste Messzyklus beginnt.

Die Messeinheit 16 kann damit die Spannung an den Leistungsschaltern 9 während einer gewünschten Zeitdauer messen. Ausgehend von diesem Wert kann die Messeinheit 16 eine Referenzspannung U'_{ref} bestimmen, die, nachdem der Schalter S1 auf die Position "Festlegen Referenzspannung U'_{ref}" gesetzt wird, an den jeweiligen Komparatoreingang angelegt wird. Der Komparatorausgang liefert dann ein Signal, das es der Messeinheit 16 erlaubt, die An- und Ausschaltzeiten der Leistungsschalter 9 zu bestimmen. Das Messen der Schaltzeiten erfolgt dabei mittels Aus- bzw. Anschalten des jeweiligen Leistungsschalters 9 für einen kurzen Zeitraum während der leitenden Phase, wie im Zusammenhang mit der folgenden Figur näher erläutert wird. Während dieser Zeit ist die Drain-Source-Spannung stets negativ. Die dem Leistungsschalter 9 in Form des MOSFET inhärente Bodydiode übernimmt, wenn der Leistungsschalter 9 ausgeschaltet wird, so dass der Betrieb des Gleichspannungswandlers 2 fortgesetzt werden kann. Die Spannung hängt entweder von der Flussspannung der Bodydiode ab, und zwar im ausgeschalteten Zustand des Leistungsschalters 9, oder von dem Produkt aus Strom und Durchlasswiderstand R_{DS,on} im eingeschalteten Zustand des Leistungsschalters 9. Die zwischen den beiden genannten Zuständen vergehende Zeit ist die An- bzw. Ausschaltzeit des entsprechenden Leistungsschalters 9.

In der in Figur 3 dargestellten Schaltungsanordnung 1' wird von der Überlegung ausgegangen, dass die beiden Leistungsschalter 9 das gleiche Verhalten in Bezug auf die Spannung U_{DS} zeigen. Falls dies nicht zutrifft, kann die gezeigte Schaltungsanordnung und insbesondere die Messeinheit dahingehend erweitert werden, dass der zweite Komparator 17 mit einer Referenzspannung versorgt wird, die verschieden von der Referenzspannung des ersten Komparators 18 ist.

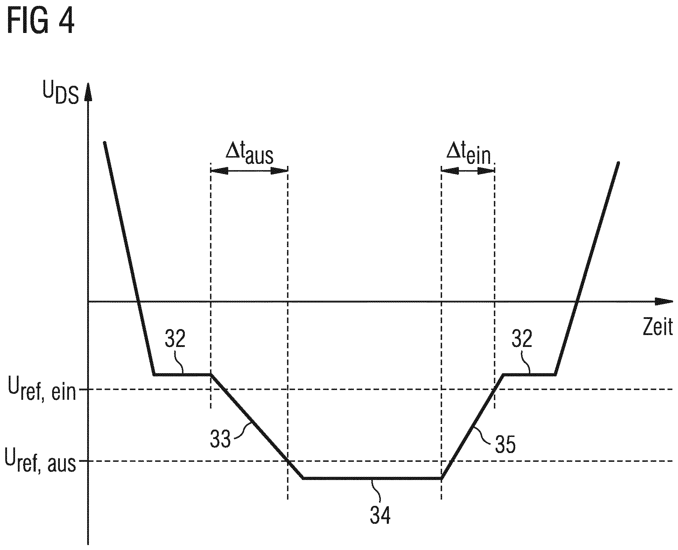

Figur 4 zeigt ein Spannungs-Zeit-Diagramm, wobei der zeitliche Verlauf der Drain-Source-Spannung U_{DS} eines der in Figur 3 gezeigten, auf der Niedervoltseite angeordneten Leistungsschalter aufgetragen ist.

Wie bereits erläutert, ist die Spannung U_{DS} durch das Produkt aus Strom und R_{DS,on} gegeben, falls der Leistungsschalter in Form eines MOSFET eingeschaltet ist. Dies entspricht einem in Figur 4 dargestellten Plateau 32 der Spannung. Bei ausgeschaltetem Leistungsschalter ist die Spannung U_{DS} gegeben durch die Flussspannung der dem MOSFET inhärenten Bodydiode. Dies entspricht einem Plateau 34 der Spannung, wobei der Absolutwert der Spannung in diesem Fall größer ist als der Absolutwert während eingeschaltetem Leistungsschalter.

Wird der Leistungsschalter vom Zustand "Ein" in den Zustand "Aus" gebracht, fällt die Spannung U_{DS} von dem Plateau 32 in einer abfallenden Flanke 33 auf das Plateau 34 ab. Wird der Leistungsschalter vom Zustand "Aus" in den Zustand "Ein" gebracht, steigt die Spannung wiederum von dem Plateau 34 über eine aufsteigende Flanke 35 auf das Plateau 32. Die Zeitdauer, in der die Spannung von dem Plateau 32 auf das Plateau 34 abfällt, entspricht dabei der Ausschalt-Dauer des Leistungsschalters, die auch als Δtₐᵤₛ bezeichnet wird. Die Zeitdauer, in der die Spannung von dem Plateau 34 auf das Plateau 32 ansteigt, entspricht der Einschalt-Dauer des Leistungsschalters, die auch als Δtₑᵢₙ bezeichnet wird.

Weiterhin sind in Figur 4 zwei Referenzspannungen U_{ref,ein} bzw. U_{ref,aus} dargestellt, wobei der Absolutwert von U_{ref,aus} größer ist als der Absolutwert von U_{ref,ein}. Mittels der genannten Schwellenwerte können, wie bereits erläutert, die entsprechenden Schaltzeiten des MOSFET bestimmt werden.

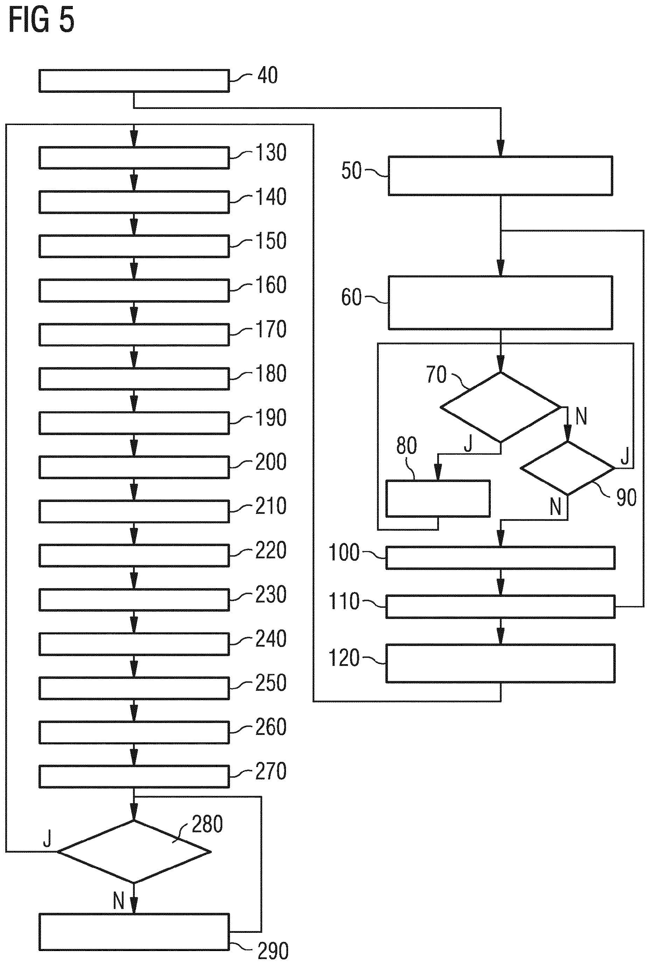

Figur 5 zeigt ein Flussdiagramm eines Verfahrens zum Ermitteln von Schaltzeiten eines Gleichspannungswandlers gemäß einer Ausführungsform der Anmeldung.

In einem Schritt 40 wird die Mess-Sequenz zum Ermitteln der Spannung U_{DS} des ersten der beiden auf der Niedervoltseite des Gleichspannungswandlers angeordneten MOSFETs begonnen.

Dazu wird in einem Schritt 50 der in Figur 3 gezeigte Schalter S1 in die Position "Messen" und der Schalter S2 in die Position "Cmp1" gebracht. Zudem werden von der Messeinheit Aktivierungssignale an die zweiten Eingänge der beiden Und-Gatter angelegt.

In einem Schritt 60 wird das von der Ansteuereinheit 3 gelieferte Signal benutzt, um den Zeitpunkt zu bestimmen, in dem sich der Strom in dem ersten MOSFET stabilisiert hat. Weiterhin wird in dem Schritt 60 von der Messeinheit 16 ein Aktivierungssignal an den Tri-State Buffer übermittelt und eine Zeitmessung gestartet.

In einem Schritt 70 wird überprüft, ob der erste Komparator einen hohen Ausgangspegel aufweist und ein Ansteuersignal zum Ansteuern des ersten MOSFET aktiv ist.

Ist dies der Fall, wird in einem Schritt 80 die Zeitmessung fortgeführt, solange der erste Komparator ein hohes Ausgangssignal liefert.

Ist dies hingegen nicht der Fall, wird in einem Schritt 90 überprüft, ob das Ansteuersignal für den ersten Leistungsschalter aktiv ist.

Ist dies der Fall, wird zu dem Schritt 70 zurückgekehrt.

Ist dies hingegen nicht der Fall, wird in einem Schritt 100 der Schalteingang des Tri-State Buffer in einen inaktiven Zustand versetzt.

Weiterhin erfolgt in einem Schritt 110 eine Mittelwertbildung sowie in einem Schritt 120 das Ermitteln des Tastverhältnisses, das heißt des Verhältnisses zwischen der Zeit, in der der Ausgang des ersten Komparators einen hohen Wert aufweist, und der Zeitdauer, in der das Ansteuersignal für den ersten Leistungsschalter aktiv ist.

Aus dem ermittelten Tastverhältnis wird in einem Schritt 130 die Referenzspannung U'_{ref} bestimmt und an den in Figur 3 gezeigten Pulsweitenmodulator zum Erzeugen der Referenzspannung U'_{ref} ausgegeben.

In einem Schritt 140 wird der Schalter S1 auf die Position "Festlegen Referenzspannung U'_{ref}" gesetzt. Weiterhin werden von der Messeinheit Aktivierungssignale an die zweiten Eingänge der beiden Und-Gatter angelegt sowie der Tri-State Buffer mittels eines entsprechenden Aktivierungssignals aktiv gesetzt.

In einem Schritt 150 wird das Ansteuersignal an den ersten MOSFET benutzt, um den Zeitpunkt zu bestimmen, zu dem der Strom in dem erste MOSFET stabil ist. Weiterhin wird in dem Schritt 150 eine Zeitmessung gestartet und der erste MOFET in den ausgeschalteten Zustand versetzt. Dies erfolgt über ein Inaktivierungs-Signal der Messeinheit an den zweiten Eingang des entsprechenden Und-Gatters des ersten MOSFET.

Die Zeitmessung erfolgt, bis der erste Komparator von einem hohen Ausgangspegel auf einen niedrigen Ausgangspegel wechselt, wie dies mit einem Schritt 160 gezeigt ist.

Daraufhin wird in einem Schritt 170 die Zeitmessung beendet und die Messdauer der ersten Zeitmessung ermittelt. Die Messdauer gibt dabei die Ausschalt-Zeit des ersten MOSFET an.

In einem Schritt 180 wird der erste MOSFET mittels eines entsprechenden Aktivierungs-Signals der Messeinheit an den zweiten Eingang des Und-Gatters eingeschaltet und eine zweite Zeitmessung gestartet.

Die Zeitmessung erfolgt daraufhin solange, bis der erste Komparator von einem niedrigen Ausgangssignal auf ein hohes Ausgangssignal wechselt, wie dies mit einem Schritt 190 dargestellt ist.
Anschließend wird in einem Schritt 200 die zweite Zeitmessung beendet und die Messdauer der zweiten Zeitmessung bestimmt. Diese Messdauer gibt die Einschalt-Zeit des ersten MOSFET an.

In einem Schritt 210 wird das Ansteuersignal an den zweiten MOSFET benutzt, um den Zeitpunkt zu bestimmen, an dem der Strom durch den zweiten MOSFET stabil ist. Daraufhin wird eine dritte Zeitmessung gestartet und der zweite MOSFET ausgeschaltet.

Die Zeitmessung wird solange durchgeführt, bis der zweite Komparator von einem hohen Ausgangssignal auf ein niedriges Ausgangssignal wechselt, wie dies mit einem Schritt 220 dargestellt ist.

In einem Schritt 230 wird daraufhin die dritte Zeitmessung beendet und die Messdauer der dritten Zeitmessung bestimmt. Diese gibt die Ausschalt-Zeit des zweiten MOSFET an.

In einem Schritt 240 wird der zweite MOSFET mittels eines entsprechenden Aktivierungs-Signals der Messeinheit an den zweiten Eingang des Und-Gatters des zweiten MOSFET wieder in den eingeschalteten Zustand versetzt und eine vierte Zeitmessung gestartet.

Die Zeitmessung erfolgt, bis der zweite Komparator von einem niedrigen Ausgangssignal in ein hohes Ausgangssignal wechselt, wie dies in einem Schritt 250 dargestellt ist.

Daraufhin wird in einem Schritt 260 die vierte Zeitmessung beendet und die Messdauer der vierten Zeitmessung bestimmt. Diese gibt die Einschalt-Zeit des zweiten MOSFET an.

In einem Schritt 270 werden in der gezeigten Ausführungsform die ermittelten Messdauern der ersten, zweiten, dritten und vierten Zeitmessung an die Ansteuereinheit ausgegeben und die Leistungsschalter in dem nächsten Betriebszyklus des Gleichspannungswandlers in Abhängigkeit der ermittelten Messdauern angesteuert.

In einem Schritt 280 wird in der gezeigten Ausführungsform ferner bestimmt, ob Veränderungen in Strom, Temperatur oder weiteren Betriebsbedingungen eingetreten sind.

Ist dies der Fall, werden die Schritte 130 bis 270 wiederholt ausgeführt.

Ist dies hingegen nicht der Fall, wird die Mess-Sequenz für U_{DS} erneut ausgeführt, wie dies mit einem Schritt 290 dargestellt ist. In diesem Fall werden die Schritte 50 bis 120 und anschließend die Schritte 130 bis 270 wiederholt ausgeführt.

## Patentansprüche

1. Schaltungsanordnung zum Ermitteln von Schaltzeiten eines Gleichspannungswandlers (2) aufweisend:
- eine Ansteuereinheit (3) ausgebildet zum Ansteuern von auf einer Hochvoltseite (4) des Gleichspannungswandlers (2) angeordneten Leistungsschaltern (5) einer Vollbrücke (6),
- zumindest eine erste Vergleichseinheit (7) ausgebildet zum Vergleichen einer, über einen auf einer Niedervoltseite (8) des Gleichspannungswandlers (2) angeordneten Leistungsschalter (9) abfallenden ersten Spannung ULV mit einer ersten vorbestimmten Referenzspannung Uref,
- eine erste Messeinheit (10) ausgebildet zum Starten einer ersten Zeitmessung, falls ein Paar der Leistungsschalter (5) der Vollbrücke (6) mittels der Ansteuereinheit (3) eingeschaltet wird, und zum Beenden der ersten Zeitmessung, falls die erste Spannung U_{LV} die erste Referenzspannung Uref überschreitet: U_{LV} > U_{ref},
wobei die erste Messeinheit (10) zudem zum Ausgeben einer ermittelten ersten Messdauer der ersten Zeitmessung an die Ansteuereinheit (3) ausgebildet ist und wobei die Ansteuereinheit (3) zum Ansteuern der Leistungsschalter (5) in Abhängigkeit der ermittelten ersten Messdauer ausgebildet ist.

2. Schaltungsanordnung nach Anspruch 1, ferner aufweisend:
- die Ansteuereinheit (3) ausgebildet zum Ansteuern von auf einer Niedervoltseite (8) des Gleichspannungswandlers (2) angeordneten Leistungsschaltern (9),
- eine Ermittlungseinheit (13) ausgebildet zum Ermitteln einer zweiten Referenzspannung U'_{ref,}
- zumindest eine zweite Vergleichseinheit (14, 15) ausgebildet zum Vergleichen einer über einen der auf der Niedervoltseite (8) des Gleichspannungswandlers (2) angeordneten Leistungsschalter (9) abfallenden zweiten Spannung U'_{LV} mit der zweiten Referenzspannung U'_{ref},
- eine zweite Messeinheit (16) ausgebildet zum Starten einer zweiten Zeitmessung, falls der Leistungsschalter (9) mittels der Ansteuereinheit (3) ausgeschaltet wird und zum Beenden der zweiten Zeitmessung, falls der Betrag |U'_{LV}| der zweiten Spannung U'_{LV} den Betrag |U'_{ref}| der zweiten Referenzspannung U'_{ref} überschreitet: |U'_{LV}| > |U'_{ref}|, und zum Starten einer dritten Zeitmessung, falls der Leistungsschalter (9) mittels der Ansteuereinheit (3) eingeschaltet wird und zum Beenden der dritten Zeitmessung, falls der Betrag |U'_{LV}| der zweiten Spannung U'_{LV} den Betrag |U'_{ref}| der zweiten Referenzspannung U'_{ref} unterschreitet: |U'_{LV}| < |U'_{ref}|,
wobei die zweite Messeinheit (16) zudem zum Ausgeben einer ermittelten zweiten Messdauer der zweiten Zeitmessung und einer ermittelten dritten Messdauer der dritten Zeitmessung an die Ansteuereinheit (3) ausgebildet ist und wobei die Ansteuereinheit (3) zum Ansteuern des Leistungsschalters (9) in Abhängigkeit der ermittelten zweiten und dritten Messdauer ausgebildet ist.

3. Schaltungsanordnung nach Anspruch 1 oder 2, wobei die zumindest eine erste Vergleichseinheit (7) als Komparator (11) ausgebildet ist oder ein Potentiometer aufweist.

4. Schaltungsanordnung nach einem der vorhergehenden Ansprüche, weiterhin aufweisend einen Pulsweitenmodulator (12) zum Erzeugen der ersten Referenzspannung U_{ref}.

5. Schaltungsanordnung zum Ermitteln von Schaltzeiten eines Gleichspannungswandlers (2) aufweisend:
- eine Ansteuereinheit (3) ausgebildet zum Ansteuern von auf einer Niedervoltseite (8) des Gleichspannungswandlers (2) angeordneten Leistungsschaltern (9),
- eine Ermittlungseinheit (13) ausgebildet zum Ermitteln einer ersten Referenzspannung U'_{ref,1} und einer zweiten Referenzspannung U'_{ref,2}, wobei gilt: |U'_{ref,1}| < |U'_{ref,2}|,
- zwei Vergleichseinheiten (14, 15) ausgebildet zum Vergleichen einer über einen der auf der Niedervoltseite (8) des Gleichspannungswandlers (2) angeordneten Leistungsschalter (9) abfallenden Spannung U'_{LV} mit jeweils einer von den beiden Referenzspannungen U'_{ref,1}, U'_{ref,2},
- eine Messeinheit (16) ausgebildet zum Starten einer ersten Zeitmessung, falls einer der Leistungsschalter (9) mittels der Ansteuereinheit (3) ausgeschaltet wird und zum Beenden der ersten Zeitmessung, falls der Betrag |U'_{LV}| der Spannung U'_{LV} den Betrag |U'_{ref,1}| der ersten Referenzspannung U'_{ref,1} überschreitet: |U'_{LV}| > |U'_{ref,1}|, und zum Starten einer zweiten Zeitmessung, falls einer der Leistungsschalter (9) mittels der Ansteuereinheit (3) eingeschaltet wird und zum Beenden der zweiten Zeitmessung, falls der Betrag |U'_{LV}| der Spannung U'_{LV} den Betrag |U'_{ref,2}| der zweiten Referenzspannung U'_{ref,2} unterschreitet: |U'_{LV}| < |U'_{ref,2}|,
wobei die Messeinheit (16) zudem zum Ausgeben einer ermittelten ersten Messdauer der ersten Zeitmessung und einer ermittelten zweiten Messdauer der zweiten Zeitmessung an die Ansteuereinheit (3) ausgebildet ist und wobei die Ansteuereinheit (3) zum Ansteuern der Leistungsschalter (9) in Abhängigkeit der ermittelten ersten und zweiten Messdauer ausgebildet ist.

6. Schaltungsanordnung nach Anspruch 5, wobei die Vergleichseinheiten (14, 15) als Komparatoren (17, 18) ausgebildet sind.

7. Schaltungsanordnung nach Anspruch 5 oder 6, wobei die Ermittlungseinheit (13) einen Dreizustandspuffer (19) und ein D-Flipflop (20) aufweist.

8. Gleichspannungswandler (2) zur Umwandlung einer Spannung einer Hochvoltseite (4) des Gleichspannungswandlers (2) in eine Spannung einer Niedervoltseite (8) des Gleichspannungswandlers (2) und/oder umgekehrt, aufweisend Leistungsschalter (5) einer Vollbrücke (6) auf der Hochvoltseite (4) des Gleichspannungswandlers (2) und/oder Leistungsschalter (9) auf der Niedervoltseite (8) des Gleichspannungswandlers (2), wobei der Gleichspannungswandler (2) eine Schaltungsanordnung (1) nach einem der vorhergehenden Ansprüche zur Steuerung der Leistungsschalter (5) der Vollbrücke (6) auf der Hochvoltseite (4) des Gleichspannungswandlers (2) und/oder der Leistungsschalter (9) auf der Niedervoltseite (8) des Gleichspannungswandlers (2) aufweist.

9. Gleichspannungswandler (2) nach Anspruch 8, wobei der auf der Hochvoltseite (4) des Gleichspannungswandlers (2) angeordnete Leistungsschalter (5) und/oder der auf der Niedervoltseite (8) des Gleichspannungswandlers (2) angeordnete Leistungsschalter (9) als Metall-Oxid- Halbleiter-Feldeffekttransistor ausgebildet sind.

10. Fahrzeug-Bordnetz aufweisend einen Gleichspannungswandler (2) nach Anspruch 8 oder 9.

11. Verfahren zum Ermitteln von Schaltzeiten eines Gleichspannungswandlers (2), wobei das Verfahren folgende Schritte aufweist:
- Starten einer Zeitmessung, falls ein Paar von auf einer Hochvoltseite (4) des Gleichspannungswandlers (2) angeordneten Leistungsschaltern (5) einer Vollbrücke (6) mittels einer Ansteuereinheit (3) eingeschaltet wird,
- Vergleichen einer, über einen auf einer Niedervoltseite (8) des Gleichspannungswandlers (2) angeordneten Leistungsschalter (9) abfallenden ersten Spannung U_{LV} mit einer ersten vorbestimmten Referenzspannung U_{ref},
- Beenden der Zeitmessung, falls die Spannung U_{LV} die Referenzspannung U_{ref} überschreitet: U_{LV} > U_{ref},
- Ausgeben einer ermittelten Messdauer der Zeitmessung an die Ansteuereinheit (3),
- Ansteuern der Leistungsschalter (5) in Abhängigkeit der ermittelten Messdauer.

12. Verfahren zum Ermitteln von Schaltzeiten eines Gleichspannungswandlers (2), wobei das Verfahren folgende Schritte aufweist:
- Ermitteln einer ersten Referenzspannung U'_{ref,1} und einer zweiten Referenzspannung U'_{ref,2}, wobei gilt: |U'_{ref,1}| < |U'_{ref,2}|,
- Starten einer ersten Zeitmessung, falls ein auf einer Niedervoltseite (8) des Gleichspannungswandlers (2) angeordneter Leistungsschalter (9) mittels einer Ansteuereinheit (3) ausgeschaltet wird,
- Vergleichen einer über den Leistungsschalter (9) abfallenden Spannung U'_{LV} mit der ersten Referenzspannung U' _{ref,1},
- Beenden der ersten Zeitmessung, falls der Betrag |U'_{LV}| der Spannung U'_{LV} den Betrag |U'_{ref,1}| der ersten Referenzspannung U'_{ref,1} überschreitet: |U'_{LV}| > |U'_{ref,1}|,
- Ausgeben einer ermittelten ersten Messdauer der ersten Zeitmessung an die Ansteuereinheit (3),
- Ansteuern des Leistungsschalters (9) in Abhängigkeit der ermittelten ersten Messdauer,
- Starten einer zweiten Zeitmessung, falls der Leistungsschalter (9) mittels der Ansteuereinheit (3) eingeschaltet wird,
- Vergleichen der über den Leistungsschalter (9) abfallenden Spannung U'_{LV} mit der zweiten Referenzspannung U'_{ref,2},
- Beenden der zweiten Zeitmessung, falls der Betrag |U'_{LV}| der Spannung U'_{LV} den Betrag |U'_{ref,2}| der zweiten Referenzspannung U'_{ref,2} unterschreitet: |U'_{LV}| < |U'_{ref,2}|,
- Ausgeben einer ermittelten zweiten Messdauer der zweiten Zeitmessung an die Ansteuereinheit (3),
- Ansteuern des Leistungsschalters (9) in Abhängigkeit der ermittelten zweiten Messdauer.

## Claims

1. Circuit arrangement for ascertaining switching times for a DC-DC voltage converter (2), comprising:
- an actuating unit (3), designed to actuate circuit breakers (5) in a full bridge (6), which are arranged on a high-volt side (4) of the DC-DC voltage converter (2) ,
- at least one first comparison unit (7), designed to compare a first voltage U_{LV} dropping across a circuit breaker (9) arranged on a low-volt side (8) of the DC-DC voltage converter (2) with a first predetermined reference voltage U_{ref,}
- a first measuring unit (10), designed to start a first time measurement when a pair of the circuit breakers (5) in the full bridge (6) is switched on by means of the actuating unit (3) and to terminate the first time measurement when the first voltage U_{LV} exceeds the first reference voltage U_{ref}: U_{LV} > U_{ref,}
wherein the first measuring unit (10) is additionally designed to output an ascertained first measurement period of the first time measurement to the actuating unit (3), and wherein the actuating unit (3) is designed to actuate the circuit breakers (5) in accordance with the ascertained first measurement period.

2. Circuit arrangement according to Claim 1, further comprising:
- the actuating unit (3), designed to actuate circuit breakers (9) arranged on a low-volt side (8) of the DC-DC voltage converter (2),
- an ascertaining unit (13), designed to ascertain a second reference voltage U'_{ref,}
- at least one second comparison unit (14, 15), designed to compare a second voltage U'_{LV} dropping across a circuit breaker (9) arranged on the low-volt side (8) of the DC-DC voltage converter (2) with the second reference voltage U'_{ref,}
- a second measuring unit (16), designed to start a second time measurement when the circuit breaker (9) is switched off by means of the actuating unit (3) and to terminate the second time measurement when the value **|U'_{LV}|** of the second voltage U'_{LV} exceeds the value **|U'_{ref}|** of the second reference voltage U'_{ref}: **|U'_{LV}|** > **|U'_{ref}|,** and to start a third time measurement when the circuit breaker (9) is switched on by means of the actuating unit (3) and to terminate the third time measurement when the value **|U'_{LV}|** of the second voltage U'_{LV} falls below the value **|U'_{ref}|** of the second reference voltage U'_{ref}: **|U'_{LV}|** < **|U'_{ref}|,**
wherein the second measuring unit (16) is additionally designed to output an ascertained second measurement period of the second time measurement and an ascertained third measurement period of the third time measurement to the actuating unit (3), and wherein the actuating unit (3) is designed to actuate the circuit breaker (9) in accordance with the ascertained second and third measurement period.

3. Circuit arrangement according to Claim 1 or 2, wherein the at least one first comparison unit (7) is formed as a comparator (11) or comprises a potentiometer.

4. Circuit arrangement according to one of the preceding claims, further comprising a pulse-width modulator (12) for generating the first reference voltage U_{ref}.

5. Circuit arrangement for ascertaining switching times for a DC-DC voltage converter (2), comprising:
- an actuating unit (3), designed to actuate circuit breakers (9) arranged on a low-volt side (8) of the DC-DC voltage converter (2),
- an ascertaining unit (13), designed to ascertain a first reference voltage U'_{ref,1} and a second reference voltage U'_{ref,2}, where: |U'_{ref,1}| < |U'_{ref,2}|,
- two comparison units (14, 15), designed to compare a voltage U'_{LV} dropping across a circuit breaker (9) arranged on the low-volt side (8) of the DC-DC voltage converter (2) with in each case one of the two reference voltages U'_{ref,1}, U'_{ref,2}'
- a measuring unit (16), designed to start a first time measurement when one of the circuit breakers (9) is switched off by means of the actuating unit (3) and to terminate the first time measurement when the value **|U'_{LV}|** of the voltage U'_{LV} exceeds the value |U'_{ref,1}| of the first reference voltage U'_{ref,1}: **|U'_{LV}|** > |U'_{ref,1}|, and to start a second time measurement when one of the circuit breakers (9) is switched on by means of the actuating unit (3) and to terminate the second time measurement when the value **|U'_{LV}|** of the voltage U'_{LV} falls below the value |U'_{ref,2}| of the second reference voltage U'_{ref,2}: **|U'_{LV}|** < **|U'_{ref,2}|**
wherein the measuring unit (16) is additionally designed to output an ascertained first measurement period of the first time measurement and an ascertained second measurement period of the second time measurement to the actuating unit (3), and wherein the actuating unit (3) is designed to actuate the circuit breakers (9) in accordance with the ascertained first and second measurement period.

6. Circuit arrangement according to Claim 5, wherein the comparison units (14, 15) are formed as comparators (17, 18) .

7. Circuit arrangement according to Claim 5 or 6, wherein the ascertaining unit (13) comprises a tri-state buffer (19) and a D-flip-flop (20).

8. DC-DC voltage converter (2) for converting a voltage of a high-volt side (4) of the DC-DC voltage converter (2) into a voltage of a low-volt side (8) of the DC-DC voltage converter (2) and/or vice versa, comprising circuit breakers (5) in a full bridge (6) on the high-volt side (4) of the DC-DC voltage converter (2) and/or circuit breakers (9) on the low-volt side (8) of the DC-DC voltage converter (2), wherein the DC-DC voltage converter (2) has a circuit arrangement (1) according to one of the preceding claims for controlling the circuit breakers (5) in the full bridge (6) on the high-volt side (4) of the DC-DC voltage converter (2) and/or the circuit breakers (9) on the low-volt side (8) of the DC-DC voltage converter (2).

9. DC-DC voltage converter (2) according to Claim 8, wherein the circuit breakers (5) arranged on the high-volt side (4) of the DC-DC voltage converter (2) and/or the circuit breakers (9) arranged on the low-volt side (8) of the DC-DC voltage converter (2) are formed as metal-oxide semiconductor field-effect transistors.

10. Vehicle on-board power supply system comprising a DC-DC voltage converter (2) according to Claim 8 or 9.

11. Method for ascertaining switching times for a DC-DC voltage converter (2), wherein the method comprises the following steps:
- starting a time measurement when a pair of circuit breakers (5) in a full bridge (6), which are arranged on a high-volt side (4) of the DC-DC voltage converter (2), is switched on by means of an actuating unit (3),
- comparing a voltage U_{LV} dropping across a circuit breaker (9) arranged on a low-volt side (8) of the DC-DC voltage converter (2) with a predetermined reference voltage U_{ref,}
- terminating the time measurement when the voltage U_{LV} exceeds the reference voltage U_{ref}: U_{LV} > U_{ref,}
- outputting an ascertained measurement period of the time measurement to the actuating unit (3),
- actuating the circuit breakers (5) in accordance with the ascertained measurement period.

12. Method for ascertaining switching times for a DC-DC voltage converter (2), wherein the method comprises the following steps:
- ascertaining a first reference voltage U'_{ref,1} and a second reference voltage U'_{ref,2}, where: |U'_{ref,1}| < |U'_{ref,2}|,
- starting a first time measurement when a circuit breaker (9) arranged on a low-volt side (8) of the DC-DC voltage converter (2) is switched off by means of an actuating unit (3),
- comparing a voltage U'_{LV} dropping across the circuit breaker (9) with the first reference voltage U'_{ref}, 1
- terminating the first time measurement when the value **|U'_{LV}|** of the voltage U'_{LV} exceeds the value |U'_{ref,1}| of the first reference voltage U'_{ref,1}: **|U'_{LV}|** > |U'_{ref,1}|,
- outputting an ascertained first measurement period of the first time measurement to the actuating unit (3),
- actuating the circuit breaker (9) in accordance with the ascertained first measurement period,
- starting a second time measurement when the circuit breaker (9) is switched on by means of the actuating unit (3),
- comparing the voltage U'_{LV} dropping across the circuit breaker (9) with the second reference voltage U'_{ref,2}
- terminating the second time measurement when the value **|U'_{LV}|** of the voltage U'_{LV} falls below the value |U'_{ref,2}| of the second reference voltage U'_{ref,2}: **|U'_{LV}|** < **|U'_{ref}|,**
- outputting an ascertained second measurement period of the second time measurement to the actuating unit (3),
- actuating the circuit breaker (9) in accordance with the ascertained second measurement period.

## Revendications

1. Arrangement de circuit destiné à déterminer les temps de commutation d'un convertisseur de tension continue (2), comprenant :
- une unité d'attaque (3) configurée pour attaquer des commutateurs de puissance (5) d'un pont intégral (6) disposés sur un côté haute tension (4) du convertisseur de tension continue (2),
- au moins une première unité de comparaison (7), configurée pour comparer une première tension U_{LV}, qui chute aux bornes d'un commutateur de puissance (9) disposé sur un côté basse tension (8) du convertisseur de tension continue (2), avec une première tension de référence U_{ref} prédéterminée,
- une première unité de mesure (10) configurée pour démarrer une première mesure de temps dans le cas où une paire de commutateurs de puissance (5) du pont intégral (6) est mise en circuit au moyen de l'unité d'attaque (3), et pour terminer la première mesure de temps dans le cas où la première tension U_{LV} dépasse la première tension de référence U_{ref} : U_{LV} > U_{ref,}
la première unité de mesure (10) étant en outre configurée pour délivrer à l'unité d'attaque (3) une première durée de mesure déterminée de la première mesure de temps et l'unité d'attaque (3) étant configurée pour attaquer les commutateurs de puissance (5) en fonction de la première durée de mesure déterminée.

2. Arrangement de circuit selon la revendication 1, comprenant en outre :
- l'unité d'attaque (3) configurée pour attaquer des commutateurs de puissance (9) disposés sur un côté basse tension (8) du convertisseur de tension continue (2),
- une unité de détermination (13) configurée pour déterminer une deuxième tension de référence U'_{ref,}
- au moins une deuxième unité de comparaison (14, 15) configurée pour comparer une deuxième tension U'_{LV,} qui chute aux bornes de l'un des commutateurs de puissance (9) disposés sur le côté basse tension (8) du convertisseur de tension continue (2), avec la deuxième tension de référence U'_{ref},
- une deuxième unité de mesure (16) configurée pour démarrer une deuxième mesure de temps dans le cas où le commutateur de puissance (9) est mis hors circuit au moyen de l'unité d'attaque (3) et pour terminer la deuxième mesure de temps dans le cas où la valeur absolue |U'_{LV}| de la deuxième tension U'_{LV} dépasse la valeur absolue |U'_{ref}| de la deuxième tension de référence U'_{ref} : |U'_{LV}| > |U'_{ref}|, et pour démarrer une troisième mesure de temps dans le cas où le commutateur de puissance (9) est mis en circuit au moyen de l'unité d'attaque (3) et pour terminer la troisième mesure de temps dans le cas où la valeur absolue |U'_{LV}| de la deuxième tension U'_{LV} devient inférieure à la valeur absolue |U'_{ref}| de la deuxième tension de référence U'_{ref} : |U'_{LV}| < |U'_{ref}|,
la deuxième unité de mesure (16) étant en outre configurée pour délivrer à l'unité d'attaque (3) une deuxième durée de mesure déterminée de la deuxième mesure de temps et une troisième durée de mesure déterminée de la troisième mesure de temps et l'unité d'attaque (3) étant configurée pour attaquer le commutateur de puissance (9) en fonction des deuxième et troisième durées de mesure déterminées.

3. Arrangement de circuit selon la revendication 1 ou 2, l'au moins une première unité de comparaison (7) étant réalisée sous la forme d'un comparateur (11) ou possédant un potentiomètre.

4. Arrangement de circuit selon l'une des revendications précédentes, possédant en outre un modulateur d'impulsions en largeur (12) destiné générer la première tension de référence U_{ref}.

5. Arrangement de circuit destiné à déterminer les temps de commutation d'un convertisseur de tension continue (2), comprenant :
- une unité d'attaque (3) configurée pour attaquer des commutateurs de puissance (9) disposés sur un côté basse tension (8) du convertisseur de tension continue (2),
- une unité de détermination (13) configurée pour déterminer une première tension de référence U'_{ref,1} et une deuxième tension de référence U'_{ref,2}, avec : |U'_{ref,1}| < |U'_{ref,2}|,
- deux unités de comparaison (14, 15), configurées pour comparer une tension U'_{LV}, qui chute aux bornes de l'un des commutateurs de puissance (9) disposés sur le côté basse tension (8) du convertisseur de tension continue (2), avec respectivement l'une des deux tensions de référence U'_{ref,1}, U'_{ref,2},
- une unité de mesure (16) configurée pour démarrer une première mesure de temps dans le cas où l'un des commutateurs de puissance (9) est mis hors circuit au moyen de l'unité d'attaque (3), et pour terminer la première mesure de temps dans le cas où la valeur absolue |U'_{LV}| de la tension U'_{LV} dépasse la valeur absolue |U'_{ref,1}| de la première tension de référence U'_{ref,1} : |U'_{LV}| > |U'_{ref,1}|, et pour démarrer une deuxième mesure de temps dans le cas où l'un des commutateurs de puissance (9) est mis en circuit au moyen de l'unité d'attaque (3), et pour terminer la deuxième mesure de temps dans le cas où la valeur absolue |U'_{LV}| de la tension U'_{LV} devient inférieure à la valeur absolue |U'_{ref,2}| de la deuxième tension de référence U'_{ref,2} : |U'_{LV}| < |U'_{ref,2}|,
l'unité de mesure (16) étant en outre configurée pour délivrer à l'unité d'attaque (3) une première durée de mesure déterminée de la première mesure de temps et une deuxième durée de mesure déterminée de la deuxième mesure de temps et l'unité d'attaque (3) étant configurée pour attaquer le commutateur de puissance (9) en fonction des première et deuxième durées de mesure déterminées.

6. Arrangement de circuit selon la revendication 5, les unités de comparaison (14, 15) étant réalisées sous la forme de comparateurs (17, 18).

7. Arrangement de circuit selon la revendication 5 ou 6, l'unité de détermination (13) possédant un tampon à trois états (19) et une bascule D (20).

8. Convertisseur de tension continue (2) destiné à convertir une tension d'un côté haute tension (4) du convertisseur de tension continue (2) en une tension d'un côté basse tension (8) du convertisseur de tension continue (2) et/ou inversement, comprenant des commutateurs de puissance (5) d'un pont intégral (6) sur le côté haute tension (4) du convertisseur de tension continue (2) et/ou des commutateurs de puissance (9) sur le côté basse tension (8) du convertisseur de tension continue (2), le convertisseur de tension continue (2) possédant un arrangement de circuit (1) selon l'une des revendications précédentes destiné à commander les commutateurs de puissance (5) du pont intégral (6) sur le côté haute tension (4) du convertisseur de tension continue (2) et/ou les commutateurs de puissance (9) sur le côté basse tension (8) du convertisseur de tension continue (2) .

9. Convertisseur de tension continue (2) selon la revendication 8, les commutateurs de puissance (5) disposés sur le côté haute tension (4) du convertisseur de tension continue (2) et/ou les commutateurs de puissance (9) disposés sur le côté basse tension (8) du convertisseur de tension continue (2) étant réalisés sous la forme de transistors à effet de champ à oxyde métallique semiconducteur.

10. Réseau de bord de véhicule comprenant un convertisseur de tension continue (2) selon la revendication 8 ou 9.

11. Procédé de détermination des temps de commutation d'un convertisseur de tension continue (2), le procédé comprenant les étapes suivantes :
- démarrage d'une mesure de temps dans le cas où une paire de commutateurs de puissance (5) d'un pont intégral (6) disposés sur un côté haute tension (4) du convertisseur de tension continue (2) est mise en circuit au moyen d'une unité d'attaque (3),
- comparaison d'une première tension U_{LV}, qui chute aux bornes d'un commutateur de puissance (9) disposé sur un côté basse tension (8) du convertisseur de tension continue (2), avec une première tension de référence U_{ref} prédéterminée,
- terminaison de la première mesure de temps dans le cas où la première tension U_{LV} dépasse la première tension de référence : U_{ref} : U_{LV} > U_{ref},
- délivrance à l'unité d'attaque (3) d'une durée de mesure déterminée du temps de mesure,
- attaque des commutateurs de puissance (5) en fonction de la durée de mesure déterminée.

12. Procédé de détermination des temps de commutation d'un convertisseur de tension continue (2), le procédé comprenant les étapes suivantes :
- détermination d'une première tension de référence U'_{ref,1} et d'une deuxième tension de référence U'_{ref,2}, avec : |U'_{ref,1}| < |U'_{ref,2}|,
- démarrage d'une première mesure de temps dans le cas où un commutateur de puissance (9) disposés sur un côté basse tension (8) du convertisseur de tension continue (2) est mis hors circuit au moyen d'une unité d'attaque (3),
- comparaison d'une tension U'_{LV}, qui chute aux bornes du commutateur de puissance (9) avec la première tension de référence U'_{ref,1},
- terminaison de la première mesure de temps dans le cas où la valeur absolue |U'_{LV}| de la tension U'_{LV} dépasse la valeur absolue |U'_{ref,1}| de la première tension de référence U'_{ref,1} : |U'_{LV}| > |U'_{ref,1}|,
- délivrance à l'unité d'attaque (3) d'une première durée de mesure déterminée du premier temps de mesure,
- attaque du commutateur de puissance (9) en fonction de la première durée de mesure déterminée,
- démarrage d'une deuxième mesure de temps dans le cas où le commutateur de puissance (9) est mis en circuit au moyen de l'unité d'attaque (3),
- comparaison de la tension U'_{LV}, qui chute aux bornes du commutateur de puissance (9) avec la deuxième tension de référence U'_{ref,2},
- terminaison de la deuxième mesure de temps dans le cas où la valeur absolue |U'_{LV}| de la tension U'_{LV} devient inférieure à la valeur absolue |U'_{ref,2}| de la deuxième tension de référence U' _{ref,2} : |U'_{LV}| < |U' _{ref,2}|,
- délivrance à l'unité d'attaque (3) d'une deuxième durée de mesure déterminée de la deuxième mesure de temps,
- attaque du commutateur de puissance (9) en fonction de la deuxième durée de mesure déterminée.
